# EUROPEAN PATENT APPLICATION

(11) **EP 4 815 686 A2**
(43) Date of publication of application: **30.09.2026**
(21) Application number: 26193282.6
(22) Date of filing: 17.12.2024
(51) Int. Cl.: H10H 29/24

(54) **LIGHT-EMITTING DEVICE AND LIGHT-EMITTING MODULE COMPRISING SAME**

(30) Priority: 19.12.2023 US 202363612014 P; 19.12.2023 US 202363612032 P; 21.12.2023 US 202363613179 P; 21.12.2023 US 202363613278 P; 16.12.2024 US 202418981991
(62) Document number(s) of the earlier application(s) in accordance with Art. 76 EPC: 24908001.1 / 4 811 977
(71) Applicant: Seoul Viosys Co., Ltd., Ansan-si, Gyeonggi-do 15429 (KR)
(72) Inventor: CHA, Nam Goo, 15429 Ansan-Si Gyeonggi-do (KR)
(74) Representative: Isarpatent

(57) **Abstract**

A light emitting module includes at least one light emitting device, wherein the light emitting device comprises: a first conductivity type semiconductor layer; a second conductivity type semiconductor layer; and an active layer interposed between the first conductivity type semiconductor layer and the second conductivity type semiconductor layer, wherein the active layer includes a multi-quantum well structure comprising barrier layers and well layers alternately disposed therein, and wherein the well layer includes at least one shading region having a lower thickness than an adjacent region.

## Description

### [Technical Field]

Embodiments of the disclosed technology relate to a light emitting device and a light emitting module including the same.

### [Background Art]

A light emitting diode (LED) refers to a light emitting device that emits light upon application of electric current thereto. In recent years, light emitting diodes have been used in various fields, such as a display apparatus, a vehicular lamp, and general lighting. Such light emitting diodes have advantages of long lifespan, low power consumption, and fast response. With such advantages, light emitting diodes are rapidly replacing typical light sources. For example, a display apparatus adopting such light emitting diodes can be obtained by forming structures of red (R), green (G), and blue (B) light emitting diodes (LEDs) separately grown on a substrate.

Specifically, a light emitting diode is formed by growing epitaxial layers on a substrate and includes an N-type semiconductor layer, a P-type semiconductor layer, and an active layer interposed therebetween. An N-electrode pad is formed on the N-type semiconductor layer and a P-electrode pad is formed on the P-type semiconductor layer, and the light emitting diode is electrically connected to an external power source through the electrode pads to drive the light emitting diode. Electric current can flow from the P-electrode pad to the N-electrode pad through the semiconductor layers and light generated through recombination of electrons and holes in the active layer can be emitted.

### [Disclosure]

### [Technical Problem]

Embodiments of the disclosed technology provide a light emitting device, which can reduce strain in a semiconductor layer doped with dopants to improve dopant doping efficiency, thereby improving luminous efficacy, and a light emitting module including the same.

Embodiments of the disclosed technology provide a light emitting device, which can improve efficiency in recombination of electrons and holes by allowing uniform injection of holes into an active layer, and a light emitting module including the same.

Embodiments of the disclosed technology provide a light emitting device having improved external quantum efficiency (EQE), and a light emitting module including the same.

Embodiments of the disclosed technology provide a light emitting device with improved reliability and high light extraction efficiency, and a light emitting module including the same.

Embodiments of the disclosed technology provide a light emitting device having high luminous efficacy and capable of improving color clarity, and a light emitting module including the same.

### [Technical Solution]

In accordance with one aspect of the disclosed technology, a light emitting module includes at least one light emitting device, the light emitting device including: a first conductivity type semiconductor layer; a second conductivity type semiconductor layer; and an active layer interposed between the first conductivity type semiconductor layer and the second conductivity type semiconductor layer, wherein the active layer includes a multi-quantum well structure including barrier layers and well layers alternately disposed therein, the well layer including at least one shading region having a lower thickness than an adjacent region.

In one embodiment, holes may have higher mobility in the shading region than holes in other regions excluding the shading region.

In one embodiment, the shading region in the well layer may have a smaller width than another shading region adjacent thereto.

In one embodiment, the thickness of the shading region may be 70% or less of the thickness of the adjacent region.

In one embodiment, the shading region may be a concavely recessed region on one surface of the well layer.

In one embodiment, a separation distance between two adjacent shading regions may be greater than the width of the shading region.

In one embodiment, the light emitting module may further include a patterned sapphire substrate on which the first conductivity type semiconductor layer disposed.

In one embodiment, a difference in energy bandgap between the second conductivity type semiconductor layer and the well layer is greater than or equal to 2 times a difference in energy bandgap between the second conductivity type semiconductor layer and the barrier layer.

In one embodiment, the light emitting module may further include a mesa structure having the active layer that have a smaller area than the first conductivity type semiconductor layer.

In one embodiment, the light emitting module may further include an ohmic layer disposed on a surface of the second conductivity type semiconductor layer.

In one embodiment, the ohmic layer may include a transparent electrode having ITO or ZnO.

In one embodiment, the light emitting module may further include a first pad electrically connected to the first conductivity type semiconductor layer and a second pad electrically connected to the second conductivity type semiconductor layer.

In one embodiment, the first pad and the second pad may include Au layer or AuSn layer.

In one embodiment, the light emitting module may further include a diffusive cover configured to cover the light emitting device to adjust light orientation.

In one embodiment, the light emitting module may be a display apparatus.

In one embodiment, the light emitting module may further include a light guide plate configured to covert spot light emitted from the light emitting device into the sheet light.

In one embodiment, light emitted from the light emitting device may have a peak wavelength of 430 nm to 480 nm, 480 nm to 550 nm, or 500 nm to 600 nm.

In one embodiment, the well layer and the barrier layer may include at least one of InGaN/GaN, GaN/AlGaN, AlGaN/AlGaN, InGaN/AlGaN, or InGaN/InGaN.

### [Advantageous Effects]

Embodiments of the disclosed technology provide a light emitting device, which can reduce strain in a semiconductor layer doped with dopants to improve dopant doping efficiency, thereby improving luminous efficacy, and a light emitting module including the same.

Embodiments of the disclosed technology provide a light emitting device, which can improve efficiency in recombination of electrons and holes by allowing uniform injection of holes into an active layer, and a light emitting module including the same.

Embodiments of the disclosed technology provide a light emitting device having improved external quantum efficiency (EQE), and a light emitting module including the same.

Embodiments of the disclosed technology provide a light emitting device with improved reliability and high light extraction efficiency, and a light emitting module including the same.

Embodiments of the disclosed technology provide a light emitting device having high luminous efficacy and capable of improving color clarity, and a light emitting module including the same.

### [Description of Drawings]

FIG. 1 is a cross-sectional view of semiconductor layers of a light emitting device according to the disclosed technology.
FIG. 2 is an enlarged sectional view of Region A in FIG. 1.
FIG. 3 is a partially enlarged sectional view of a light emitting device according to one embodiment.
FIG. 4A is a partially enlarged sectional view of a light emitting device according to another embodiment.
FIG. 4B is a partially enlarged sectional view of a variant of the light emitting device of FIG. 4A.
FIG. 5 is a plan view of a light emitting device according to another embodiment of the disclosed technology.
FIG. 6 is a cross-sectional view taken along line A-A' of FIG. 5.
FIG. 7 is a side sectional view of a light emitting device according to another embodiment of the disclosed technology.
FIG. 8 is a side sectional view of a variant of the light emitting device of FIG. 7.
FIG. 9A is a side -sectional view of a light emitting module according to a first embodiment of the disclosed technology.
FIG. 9B is a side sectional view of a variant of the light emitting device of FIG. 9A.
FIG. 10 is a plan view of a light emitting module according to a second embodiment of the disclosed technology.
FIG. 11 is a side view of a light emitting module according to a third embodiment of the disclosed technology.
FIG. 12 is a side sectional view of a light emitting module according to a fourth embodiment of the disclosed technology.
FIG. 13 is an exploded perspective view of a light emitting module according to a fifth embodiment of the disclosed technology.
FIG. 14 is a side sectional view of a light emitting module according to a sixth embodiment of the disclosed technology.
FIG. 15 is a side view of a light emitting module according to a seventh embodiment of the disclosed technology.
FIG. 16 is a plan view of the light emitting module according to the seventh embodiment of the disclosed technology.

### [Best Mode]

In the following description, for the purposes of explanation, numerous specific details are set forth in order to provide thorough understanding of various exemplary embodiments or implementations of the disclosed technology. As used herein, "embodiments" and "implementations" are interchangeable terms for non-limiting examples of devices or methods employing one or more of the inventive concepts disclosed herein. It will be apparent, however, that various exemplary embodiments may be practiced without these specific details or with one or more equivalent arrangements. In other instances, well-known structures and devices are shown in block diagram form in order to avoid unnecessarily obscuring various exemplary embodiments. Further, various exemplary embodiments may be different, but do not have to be exclusive. For example, specific shapes, configurations, and characteristics of an exemplary embodiment may be used or implemented in another exemplary embodiment without departing from the inventive concepts.

Unless otherwise specified, the illustrated exemplary embodiments are to be understood as providing exemplary features of varying detail of some ways in which the inventive concepts may be implemented in practice. Therefore, unless otherwise specified, the features, components, modules, layers, films, panels, regions, and/or aspects (hereinafter individually or collectively referred to as "elements") of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, and property of the elements, unless specified. Further, in the accompanying drawings, the size and relative sizes of elements may be exaggerated for clarity and/or descriptive purposes. When an exemplary embodiment is implemented differently, a specific process order may be performed differently from the described order. For example, two consecutively described processes may be performed substantially at the same time or performed in an order opposite the described order. In addition, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the DR1-axis, the DR2-axis, and the DR3-axis are not limited to three axes of a rectangular coordinate system, such as the x, y, and z-axes, and may be interpreted in a broader sense. For example, the DR1-axis, the DR2-axis, and the DR3-axis may be perpendicular to one another, or may represent different directions that are not perpendicular to one another. For the purposes of this disclosure, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, and ZZ. As used herein, the term "and/or" includes any and all combinations of one or more of the associated listed items.

Although the terms "first," "second," and the like may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (for example, as in "sidewall"), and the like, may be used herein for descriptive purposes, and, thereby, to describe one element's relationship to other element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the exemplary term "below" can encompass both an orientation of above and below. Furthermore, the apparatus may be otherwise oriented (for example, rotated 90 degrees or at other orientations), and, as such, the spatially relative descriptors used herein may likewise interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various exemplary embodiments are described herein with reference to sectional and/or exploded illustrations that are schematic illustrations of idealized exemplary embodiments and/or intermediate structures. As such, variations from the shapes of the illustrations as a result, for example, of manufacturing techniques and/or tolerances, are to be expected. Thus, exemplary embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some exemplary embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, or others, which may be formed using semiconductor-based fabrication techniques or other manufacturing technologies. In the case of the blocks, units, and/or modules being implemented by microprocessors or other similar hardware, they may be programmed and controlled using software (for example, microcode) to perform various functions discussed herein and may optionally be driven by firmware and/or software. It is also contemplated that each block, unit, and/or module may be implemented by dedicated hardware, or as a combination of dedicated hardware to perform some functions and a processor (for example, one or more programmed microprocessors and associated circuitry) to perform other functions. Also, each block, unit, and/or module of some exemplary embodiments may be physically separated into two or more interacting and discrete blocks, units, and/or modules without departing from the scope of the inventive concepts. Further, the blocks, units, and/or modules of some exemplary embodiments may be physically combined into more complex blocks, units, and/or modules without departing from the scope of the inventive concepts.

Unless otherwise defined, all terms (including technical and scientific terms) used herein have the same meaning as commonly understood by one of ordinary skill in the art to which this disclosure pertains. Terms, such as those defined in commonly used dictionaries, should be interpreted as having a meaning that is consistent with their meaning in the context of the relevant art and should not be interpreted in an idealized or overly formal sense, unless expressly so defined herein.

Hereinafter, a light emitting device according to the disclosed technology and a light emitting module including the same will be described in detail with reference to the drawings.

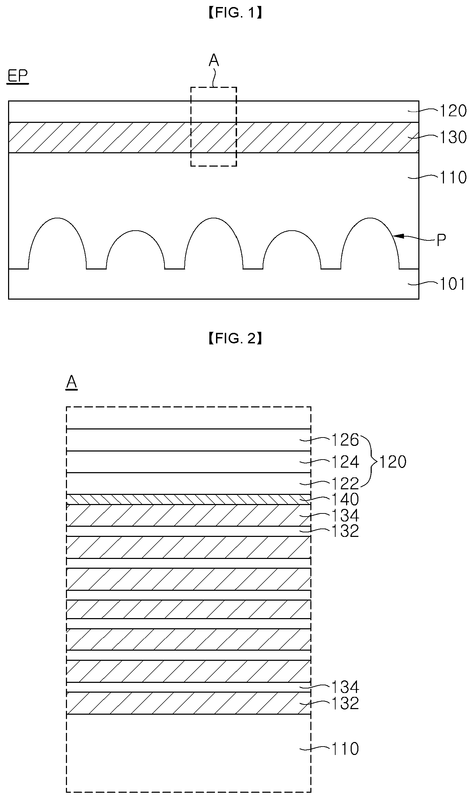

Referring to FIG. 1, the light emitting device 100 may include a semiconductor layer EP for generating and emitting light. Specifically, the semiconductor layer EP of the light emitting device 100 may include a first conductivity type semiconductor layer 110, a second conductivity type semiconductor layer 120, and an active layer 130 interposed between the first conductivity type semiconductor layer 110 and the second conductivity type semiconductor layer 120.

The first conductivity type semiconductor layer 110 may include a phosphide or nitride semiconductor, such as (Al, Ga, In)P or (Al, Ga, In)N, and may be formed on a growth substrate through a method, such as MOCVD, MBE, HVPE, or the like. By way of example, the first conductivity type semiconductor layer 110 may be a nitride semiconductor layer doped with a first conductivity type dopant and may include, for example, an InxAlyGa(1-x)N (0≤x≤0, 0≤y≤1, 0≤x+y<1) layer doped with Si as the first conductivity type dopant.

In addition, the first conductivity type semiconductor layer 110 may be doped with at least one type of n-type dopant, such as Si, C, Ge, Sn, Te, Pb, or others, without being limited thereto. Alternatively, the first conductivity type semiconductor layer 110 may be doped with a p-type dopant to become an opposite conductivity type. The first conductive type dopant may have a doping concentration of the first conductivity type dopant in the range of 5×1017 atoms/cm3 to 5×1019 atoms/cm3.

The first conductivity type semiconductor layer 110 may have a single layer structure or may include multiple layers. The first conductivity type semiconductor layer 110 may further include a nucleation layer and a buffer layer. The first conductivity type semiconductor layer 110 may further include a superlattice layer. The superlattice layer may be formed on the first conductivity type semiconductor layer 110.

The second conductivity type semiconductor layer 120 may include a phosphide or nitride semiconductor, such as (Al, Ga, In)P or (Al, Ga, In)N, and may be grown by a technique, such as MOCVD, MBE, or HVPE. The second conductivity type semiconductor layer 120 may be doped with a second conductivity type dopant to become a conductivity type opposite to the conductivity type of the first conductivity type semiconductor layer 110. For example, the second conductivity type semiconductor layer 120 may be doped with p-type dopants, such as Mg. The second conductivity type semiconductor layer 120 may include, for example, InxAlyGa1-x-yN (0≤x≤1, 0≤y≤1, 0≤x+y<1).

The second conductivity type semiconductor layer 120 may include a single layer or a plurality of layers, each having a composition of, for example, p-InxAlyGa1-x-yN (0≤x≤1, 0≤y≤1, 0≤x+y<1). For example, the second conductivity type semiconductor layer 120 may include a second-1 conductivity type semiconductor layer 122 and a second-2 conductivity type semiconductor layer 124 disposed at one side of the second-1 conductivity type semiconductor layer 122. The second conductivity type semiconductor layer 120 may further include a second-3 conductive type semiconductor layer 126 on the second-2 conductivity type semiconductor layer 124. The second conductivity type semiconductor layer 120 may further include an Al-containing layer. In addition, the second conductivity type semiconductor layer 120 may further include a superlattice layer. The second conductivity type semiconductor layer 120 may further include a second conductivity type contact layer.

The active layer 130 may refer to a light emitting layer interposed between the first conductivity type semiconductor layer 110 and the second conductivity type semiconductor layer 120. The active layer 130 may be disposed on a surface of the first conductivity type semiconductor layer 110.

The active layer 130 may include a phosphide or nitride semiconductor, such as (Al, Ga, In)P or (Al, Ga, In)N, and may be grown on a surface of the first conductivity type semiconductor layer 110 by a technique, such as MOCVD, MBE, or HVPE.

The active layer 130 may include a quantum well (QW) structure including at least two barrier layers 132 and at least one well layer 134. Alternatively, the active layer 130 may include a multi-quantum well (MQW) structure of barrier layers 132 and well layers 134 alternately disposed. The multi-quantum well may include pluralities of barrier layers 132 and well layers 134, which are alternately stacked one above another. A barrier layer 132 and a well layer 134 adjacent thereto may constitute a pair. The active layer 130 may include a plurality of pairs.

The well layers 134 and the barrier layers 132 may be formed of a semiconductor material having a composition of, for example, InxAlyGa(1-x-y)N (0≤x≤1, 0≤y≤1, 0≤x+y<1). For example, the well layers 134 and the barrier layers 132 may include at least one of InGaN/GaN, GaN/AlGaN, AlGaN/AlGaN, InGaN/AlGaN, or InGaN/InGaN.

The wavelength of light emitted from the active layer 130 may be adjusted by controlling the composition of materials constituting the well layers 134. The composition and thickness of the well layers 134 can determine the wavelength of light generated in the active layer. In particular, the composition of the well layers 134 may be adjusted to provide an active layer 130 that produces ultraviolet light, blue light, red light, or green light.

In an alternative embodiment, the active layer 130 may include a sub-active layer and a main active layer. The sub-active layer may be disposed on the first conductivity type semiconductor layer 110. The sub-active layer may include a first sub-active layer and a second sub-active layer disposed on the first sub-active layer. The main active layer may include barrier layers 132 and well layers 134 alternately stacked one above another.

The first conductivity type semiconductor layer 110, the active layer 130, and the second conductivity type semiconductor layer 120 may constitute a semiconductor stack and may form a light emitting structure that emits light having a predetermined peak wavelength. That is, the semiconductor stack may emit light, such as blue, green, or red light.

Specifically, the semiconductor stack configured to emit blue light may have a dominant wavelength within the blue wavelength band, specifically a dominant wavelength of 440 nm to 480 nm.

The semiconductor stack configured to emit green light may have a dominant wavelength within the green wavelength band, specifically a dominant wavelength of 480 nm to 580 nm. A peak wavelength of the light emitting device 100 configured to emit green light may be shorter than the dominant wavelength thereof.

The semiconductor stack configured to emit red light may have a dominant wavelength within the red wavelength band, specifically, a dominant wavelength of 600 nm to 650 nm. A peak wavelength of the light emitting device 100 configured to emit red light may be longer than the dominant wavelength thereof.

Referring to FIG. 2, when the first conductivity type semiconductor layer 110 includes the superlattice layer, the active layer 130 may be disposed between the superlattice layer and the second conductivity type semiconductor layer 120.

The first conductivity type semiconductor layer 110 may have an energy bandgap level closer to an energy bandgap level of the barrier layer 132 than an energy bandgap level of the well layer 134. The second conductivity type semiconductor layer 120 may have an energy bandgap level closer to the energy bandgap level of the barrier layer 132 than the energy bandgap level of the well layer 134. As a result, deformation of the energy band of the barrier layer 132 disposed between the first conductivity type semiconductor layer 110 and the second conductivity type semiconductor layer 120 can be reduced, thereby improving efficiency of trapping electrons and holes in the well layers.

A difference in energy bandgap between the first conductivity type semiconductor layer 110 and the well layer 134 may be greater than or equal to 2 times a difference in energy bandgap between the first conductivity type semiconductor layer 110 and the barrier layer 132. A difference in energy bandgap between the second conductivity type semiconductor layer 120 and the well layer 134 may be greater than or equal to 2 times a difference in energy bandgap between the second conductivity type semiconductor layer 120 and the barrier layer 132. Such a large energy bandgap difference can reduce escape probability of electrons and holes.

In division of an upper region and a lower region with reference to a midpoint of the energy bandgap difference between the well layer 134 and the barrier layer 132, at least one of the first conductivity type semiconductor layer 110 and the second conductivity type semiconductor layer 120 may have an energy bandgap level in the upper region.

The light emitting device 100 may further include an electron blocking layer 140 between the active layer 130 and the second conductive type semiconductor layer 120.

The electron blocking layer 140 may have a relatively large energy bandgap. The electron blocking layer 140 is placed at one side of the active layer 130 and serves to prevent electrons from overflowing from the active layer 130 to the second conductivity type semiconductor layer 120. The electron blocking layer 140 may be formed of, for example, an InxAlyGa1-x-yN (0≤x≤1, 0≤y≤1, 0≤x+y<1) material.

The electron blocking layer 140 may be disposed on the uppermost barrier layer 132 of the active layer 130. The electron blocking layer 140 may have a larger average energy bandgap than the uppermost barrier layer 132. The energy barrier of the electron blocking layer 140 may block electrons of the active layer 130 from migrating to the second conductive type semiconductor layer 120.

The electron blocking layer 140 may include an Al composition. For example, the electron blocking layer 140 may include AlGaN.

The second-1 conductivity type semiconductor layer 122 may be disposed on the electron blocking layer 140. That is, the second-1 conductivity type semiconductor layer 122 may be disposed at one side of the electron blocking layer 140 and the second-2 conductivity type semiconductor layer 124 may be disposed at one side of the second-1 conductivity type semiconductor layer 122.

The second-1 conductivity type semiconductor layer 122 may be a layer doped with a high concentration of the second conductivity type dopant. The second-1 conductivity type semiconductor layer 122 may have a higher concentration of the second conductivity type dopant than the second-2 conductivity type semiconductor layer 124.

The energy bandgap difference between the first conductivity type semiconductor layer 110 and the barrier layer 132 may be smaller than the energy bandgap difference between the first conductivity type semiconductor layer 110 and the electron blocking layer 140. In addition, the energy bandgap difference between the second conductivity type semiconductor layer 120 and the barrier layer 132 may be smaller than the energy bandgap difference between the second conductivity type semiconductor layer 120 and the electron blocking layer 140.

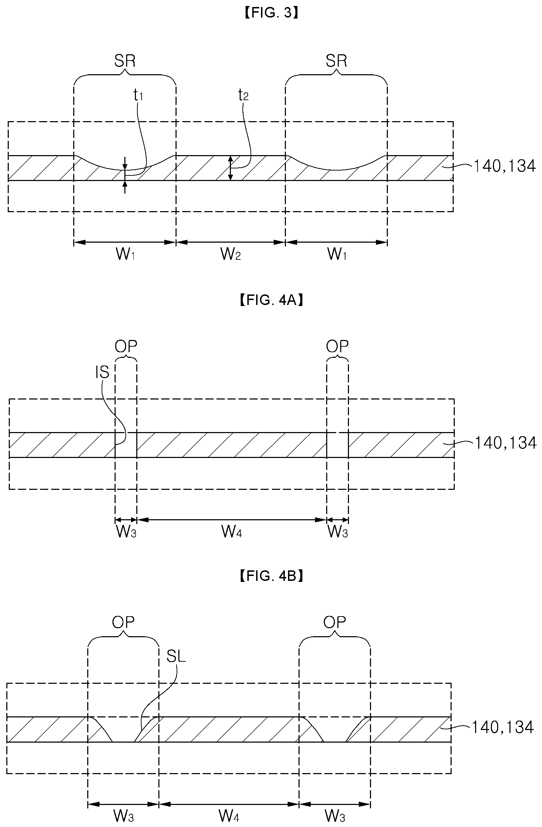

In the light emitting device 100 according to a first embodiment, the electron blocking layer 140 may include a shading region SR. Referring to FIG. 3, the shading region SR may refer to a region of the electron blocking layer 140, which has a smaller thickness than an adjacent region.

For example, a thickness t1 of the shading region SR in the electron blocking layer 140 may be 70% or less of a thickness t2 of the adjacent region. Here, the thickness t1 of the shading region SR may refer to a minimum thickness in the shading region SR.

A difference in lattice constant between the electron blocking layer 140 in the shading region SR and the second conductivity type semiconductor layer 120 may be less than a difference in lattice constant between the electron blocking layer 140 in other regions excluding the shading region SR and the second conductivity type semiconductor layer 120.

The lattice constant of the electron blocking layer 140 may be significantly different from the lattice constant of the second conductivity type semiconductor layer 120. As a result, a large strain can be induced in the second conductivity type semiconductor layer 120. When a large strain is induced in the second conductivity type semiconductor layer 120, the doping efficiency of the second conductivity type dopant in the second conductivity type semiconductor layer 120 can be deteriorated. Since deterioration in doping efficiency of the second conductivity type semiconductor layer 120 results in deterioration in generation efficiency of holes, the active layer 130 can also suffer from deterioration in light generation efficiency.

However, since the shading region SR of the electron blocking layer 140 has a smaller thickness t1 than the other regions thereof, the difference in lattice constant between the electron blocking layer 140 in the shading region SR and the second conductivity type semiconductor layer 120 can be relieved. As a result, the strain in the second conductivity type semiconductor layer 120 can be relieved while improving the doping efficiency in the second conductivity type semiconductor layer 120, thereby improving light generation efficiency.

The number of shading regions SR may be determined in various ways and the shading regions SR may be disposed at various locations within the electron blocking layer 140.

The shading region SR may have the same or different width W1 than another shading region SR adjacent thereto. By way of example, in the electron blocking layer 140, the width W1 of the shading region SR may be less than the width W1 of an adjacent shading region SR. Here, the width W1 of the shading region SR may refer to a width of the shading region SR in cross-sectional view.

In the electron blocking layer 140, a separation distance W2 between two adjacent shading regions SR may be different from the width W1 of the shading region SR. Here, the separation distance W2 between two adjacent shading regions SR may refer to a straight distance between the two adjacent shading regions SR. The separation distance W2 between the two adjacent shading regions SR may be different from the width W1 of the shading region SR. By way of example, the separation distance W2 between the two adjacent shading regions SR may be greater than the width W1 of the shading region SR.

When the shading region SR is provided in plural, the shading regions SR may be uniformly distributed or may be concentrated in a certain region.

The shading region SR may be a concavely recessed region on a surface of the electron blocking layer 140. The concavely recessed region may be formed on an upper surface of the electron blocking layer 140, a lower surface thereof, or both the upper and lower surfaces thereof.

In the light emitting device 100 according to a second embodiment, the electron blocking layer 140 may include an open region OP. Referring to FIG. 4A, the open region OP may refer to a region of the electron blocking layer 140 penetrated in the vertical direction.

Since the open region OP is a via-hole region, the uppermost barrier layer 132 of the active layer 130 may contact the second conductivity type semiconductor layer 120. Therefore, a difference in lattice constant between the barrier layer 132 in the open region OP and the second conductivity type semiconductor layer 120 may be less than a difference in lattice constant between the barrier layer 132 in other regions excluding the open region OP and the second conductivity type semiconductor layer 120.

The lattice constant of the electron blocking layer 140 may be significantly different from the lattice constant of the second conductivity type semiconductor layer 120. Accordingly, a large strain can be induced in the second conductivity type semiconductor layer 120. When a large strain is induced in the second conductivity type semiconductor layer 120, the doping efficiency of the second conductivity type dopant in the second conductivity type semiconductor layer 120 can be deteriorated. Since deterioration in doping efficiency of the second conductivity type semiconductor layer 120 results in deterioration in generation efficiency of holes, the active layer 130 can also suffer from deterioration in light generation efficiency.

However, since the open region OP of the electron blocking layer 140 is a via-hole region, the difference in lattice constant between the electron blocking layer 140 in the open region OP and the second conductivity type semiconductor layer 120 can be relived. As a result, the strain in the second conductivity type semiconductor layer 120 can be relieved while improving the doping efficiency of the second conductivity type semiconductor layer 120, thereby improving light generation efficiency. Further, the injection rate of holes may be increased by allowing the holes to be drawn into the open region OP.

The number of open regions OR may be determined in various ways and the open regions OR may be disposed at various locations within the electron blocking layer 140.

The open region OR may have the same or different width W3 than another open region OR adjacent thereto. By way of example, in the electron blocking layer 140, the width W3 of the open region OR may be less than the width W3 of the adjacent open region OR. Here, the width W3 of the open region OR may refer to a width of the open region OR in cross-sectional view.

In the electron blocking layer 140, a separation distance W4 between two adjacent open regions OR may be different from the width W2 of the open region OR. Here, the separation distance W4 between two adjacent open regions OR may refer to a straight distance between the two adjacent open regions OR. The separation distance W4 between the two adjacent open regions OR may be different from the width W3 of the open region OR. By way of example, the separation distance W4 between the two adjacent open regions OR may be greater than the width W3 of the open region OR.

When the open region OP is provided in plural, the open regions OPs may be uniformly distributed or may be concentrated in a certain region.

The open region OP may have various shapes in plan view. For example, the open region OP is not limited to a particular shape, such as a circular shape, an elliptical shape, a square shape, or others.

The open region OP may include an inlet and an outlet disposed opposite the inlet. The inlet may refer to an entrance for holes to enter the open region OP and the outlet may refer to an exit for holes to exit the open region OP after passing through the open region OP. The inlet may be placed at one end of the open region OP and the outlet may be placed at the other end of the open region OP. The inlet may have a width corresponding to a diameter of an edge of the inlet. The outlet may have a width corresponding to a diameter of an edge of the outlet.

The open region may include a side surface connecting the edge of the inlet to the edge of the outlet. The side surface may correspond to an inner circumferential surface IS defining the open region OP. The side surface may be perpendicular or inclined with respect to a horizontal direction of the electron blocking layer 140.

Although FIG. 4A illustrates an example wherein the inner circumferential surface IS defining the open region OP is a vertical plan, it should be understood that other implementations are possible. In this example, the width of the inlet may be the same as the width of the outlet. The side surface connecting the edge of the inlet to the edge of the outlet forms the inner circumference surface IS, which may be a vertical surface.

In another example, referring to FIG. 4B, a sloped surface SL may be formed at an edge defining the open region OP. The sloped surface SL may have a constant inclination or a variable inclination depending on the location thereof. Due to the sloped surface SL, the open region OP may have a different width between a lower end thereof and an upper end thereof. That is, the width of the inlet may be different from the width of the outlet. By way of example, the lower end (or outlet) of the open region OP may have a greater width than the upper end (or inlet) thereof. Alternatively, the lower end (or outlet) of the open region OP may have a smaller width than the upper end (or inlet) thereof. As such, the velocity of holes can be controlled by varying widths of the inlet and the outlet of the open region OP through which the holes pass.

The electron blocking layer 140 may include at least one of the shading region SR or the open region OP. That is, the electron blocking layer 140 may include both the shading region SR and the open region OP.

In the light emitting device 100 according to a third embodiment, the well layer 134 may include a shading region SR. For the light emitting device 100 including a plurality of well layers 134, at least one well layer 134 may include the shading region SR. Referring to FIG. 3, the shading region SR may refer to a region of the well layer 134 that has a smaller thickness than an adjacent region thereof.

For example, the thickness t1 of the shading region SR in the well layer 134 may be 70% or less of the thickness t2 of the adjacent region. Here, the thickness t1 of the shading region SR may refer to a minimum thickness in the shading region SR.

The well layer 134 refers to a layer having a narrower energy bandgap than the barrier layer 132 and has a structure in which a semiconductor layer having a narrower energy bandgap than the barrier layer 132 is interposed between the barrier layers 132, that is, semiconductor layers having a larger energy bandgap. The well layer 134 and the barrier layer 132 have a heterojunction structure and strain due to a difference in lattice constant between the well layer 134 and the barrier layer 132 and transition energy due to a quantum confinement effect can be changed depending on the thickness of the well layer 134.

Since the shading region SR of the well layer 134 has a smaller thickness t1 than other regions thereof, a difference in lattice constant between the well layer 134 in the shading region SR and the barrier layer 132 may be less than a difference in lattice constant between the well layer 134 in the other region excluding the shading region SR and the barrier layer 132. In addition, a probability of holes being trapped in the well layer 134 is reduced in the shading region SR of the well layer 134, thereby allowing more efficient migration of the holes to an adjacent barrier layer 134 and rapid and uniform diffusion of the holes across all of the well layers 134 within the active layer 130. As a result, electrons and holes can be more uniformly coupled to each other throughout the active layer 130, thereby allowing uniform generation and emission of light.

The number of shading regions SR may be determined in various ways and the shading regions SR may be disposed at various locations within the well layer 134.

The shading region SR may have the same or different width W1 than another shading region SR adjacent thereto. By way of example, in the well layer 134, the width W1 of the shading region SR may be less than the width W1 of the adjacent shading region SR. Here, the width W1 of the shading region SR may refer to a width of the shading region SR in cross-sectional view.

In the well layer 134, a separation distance W2 between two adjacent shading regions SR may be different from the width W1 of the shading region SR. Here, the separation distance W2 between two adjacent shading regions SR may refer to a straight distance between the two adjacent shading regions SR. The separation distance W2 between the two adjacent shading regions SR may be different from the width W1 of the shading region SR. By way of example, the separation distance W2 between the two adjacent shading regions SR may be greater than the width W1 of the shading region SR.

When the well layer 134 is provided with a plurality of shading region SR, the shading regions SR may be uniformly distributed or may be concentrated in a certain region.

The shading region SR may be a concavely recessed region on a surface of the well layer 134. The concavely recessed region may be formed on an upper surface of the well layer 134, on a lower surface thereof, or on both the upper and lower surfaces thereof.

In the light emitting device 100 according to a fourth embodiment, the well layer 134 may include an open region OP. For the light emitting device 100 including a plurality of well layers 134, at least one well layer 134 may include the open region OP. Referring to FIG. 4A, the open region OP may refer to a region of the well layer 134 penetrated in the vertical direction.

The well layer 134 refers to a layer having a narrower energy bandgap than the barrier layer 132 and has a structure in which a semiconductor layer having a narrower energy bandgap than the barrier layer 132 is interposed between the barrier layers 132, that is, semiconductor layers having a larger energy bandgap. The well layer 134 and the barrier layer 132 have a heterojunction structure and strain due to a difference in lattice constant between the well layer 134 and the barrier layer 132 and transition energy due to a quantum confinement effect can be changed depending on the thickness of the well layer 134.

Since the open region SR of the well layer 134 is a via-hole region, the barrier layer 132 adjacent to one side of the well layer 134 may contact the barrier layer 132 adjacent to the other side thereof. Therefore, a difference in lattice constant between the well layer 134 in the open region OP and the barrier layer 132 may be less than a difference in lattice constant between the well layer 134 in other regions excluding the open region OP and the barrier layer 132. In addition, a probability of holes being trapped in the well layer 134 is reduced in the open region OP of the well layer 134, thereby allowing more efficient migration of the holes to an adjacent barrier layer 134 and rapid and uniform diffusion of the holes across all of the well layers 134 within the active layer 130. As a result, electrons and holes can be more uniformly coupled throughout the active layer 130, thereby allowing uniform generation and emission of light. In addition, light can be emitted from the side surface of the open region OP, thereby improving lateral light extraction efficiency.

The number of open regions OR may be determined in various ways and the open regions OR may be disposed at various locations within the well layer 134.

The open region OR may have the same or different width W3 than another open region OR adjacent thereto. By way of example, in the well layer 134, the width W3 of the open region OR may be less than the width W3 of the adjacent open region OR. Here, the width W3 of the open region OR may refer to a width of the open region OR in cross-sectional view.

In the well layer 134, a separation distance W4 between two adjacent open regions OR may be different from the width W2 of the open region OR. Here, the separation distance W4 between two adjacent open regions OR may refer to a straight distance between the two adjacent open regions OR. The separation distance W4 between the two adjacent open regions OR may be different from the width W3 of the open region OR. By way of example, the separation distance W4 between the two adjacent open regions OR may be greater than the width W3 of the open region OR.

When the well layer 134 is provided with a plurality of open regions OPs, the open regions OPs may be uniformly distributed or may be concentrated in a certain region.

The open region OP may have various shapes in plan view. For example, the OP is not limited to a particular shape, such as a circular shape, an elliptical shape, a square shape, or others.

The open region OP may include an inlet and an outlet disposed opposite the inlet. The inlet may refer to an entrance for holes to enter the open region OP and the outlet may refer to an exit for holes to exit the open region OP after passing through the open region OP. The inlet may be placed at one end of the open region OP and the outlet may be placed at the other end of the open region OP. The inlet may have a width corresponding to a diameter of an edge of the inlet. The outlet may have a width corresponding to a diameter of an edge of the outlet.

The open region may include a side surface connecting the edge of the inlet to the edge of the outlet. The side surface may correspond to an inner circumferential surface IS defining the open region OP. The side surface may be perpendicular or inclined with respect to a horizontal direction of the well layer 134.

Although FIG. 4A illustrates an example wherein the inner circumferential surface IS defining the open region OP is a vertical plan, it should be understood that other implementations are possible. In this example, the width of the inlet may be the same as the width of the outlet. The side surface connecting the edge of the inlet to the edge of the outlet forms the inner circumference surface IS, which may be a vertical surface.

In another example, referring to FIG. 4B, a sloped surface SL may be formed at an edge defining the open region OP. The sloped surface SL may have a constant inclination or a variable inclination depending on the location thereof. Due to the sloped surface SL, the open region OP may have a different width between a lower end thereof and an upper end thereof. That is, the width of the inlet may be different from the width of the outlet. By way of example, the lower end (or outlet) of the open region OP may have a greater width than the upper end (or inlet) thereof. Alternatively, the lower end (or outlet) of the open region OP may have a smaller width than the upper end (or inlet) thereof. As such, the velocity of the holes can be controlled by different widths of the inlet and the outlet of the open region OP through which the holes pass.

When each of the plurality of well layers 134 includes the open region OP, the open regions OP may be placed to overlap each other in a thickness direction. Alternatively, the open regions OP may be placed so as not to overlap each other in the thickness direction.

The well layer 134 may include at least one of the shading region SR or the open region OP. That is, the well layer 134 may include both the shading region SR and the open region OP.

Further, one of the well layers 134 may include the shading region SR and the other well layer 134 may include the open region OP. Alternatively, one well layer 134 may include both the shading region SR and the open region OP.

When the electron blocking layer 140 includes at least one of the shading region SR or the open region OP, the well layer 134 may also include at least one of the shading region SR or the open region OP. Alternatively, when the electron blocking layer 140 includes at least one of the shading region SR or the open region OP, the well layer 134 may include neither the shading region SR nor the open region OP. Alternatively, when the well layer 134 includes at least one of the shading region SR or the open region OP, the electron blocking layer 140 may also include at least one of the shading region SR or the open region OP. Alternatively, when the well layer 134 includes at least one of the shading region SR or the open region OP, the electron blocking layer 140 may include neither the shading region SR nor the open region OP.

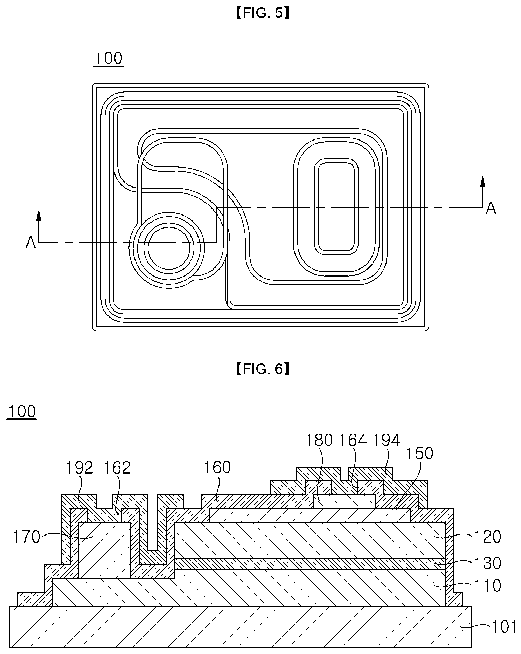

Next, FIG. 5 shows a light emitting device 100 according to one embodiment of the disclosed technology, in which the light emitting device 100 may include the aforementioned semiconductor layer. The light emitting device 100 may include a mesa M disposed in a region of the first conductivity type semiconductor layer 110 to expose an upper surface of the first conductivity type semiconductor layer 110, an ohmic layer 150 disposed on a surface of the second conductivity type semiconductor layer 150, and an insulating layer 160 covering at least a portion of the mesa M. FIG. 6 is a cross-sectional view taken along line A-A' of FIG. 5.

The first conductivity type semiconductor layer 110 may be disposed on a substrate 101. The substrate 101 may be a growth substrate allowing growth of semiconductor layers thereon. The substrate 101 is not limited to a particular substrate so long as the semiconductor layers can be grown on the substrate, and may include, for example, a sapphire substrate, a gallium nitride substrate, a SiC substrate, a spinel substrate, or others. The substrate 101 may be a patterned substrate having a pattern formed on a surface thereof, on which the first conductivity type semiconductor layer 110 is grown. Here, the substrate 101 may include irregularities or protrusions P on a surface thereof. When the substrate 101 is a patterned sapphire substrate, a patterned region of the substrate may include two materials having different indexes of refraction.

The substrate 101 may have a rectangular shape or a square shape in plan view, without being limited thereto. The substrate 101 may have various shapes instead of being limited to a particular shape. The substrate 101 may be omitted.

Referring to FIG. 5 and FIG. 6, the mesa M may refer to a structure formed by etching the semiconductor layers to expose the upper surface of the first conductivity type semiconductor layer 110. Accordingly, the second conductivity type semiconductor layer 120 and the active layer 130 may have a smaller area than the first conductivity type semiconductor layer 110. The mesa M may include a region of the first conductivity type semiconductor layer 110.

The upper surface of the first conductivity type semiconductor layer 110 may be exposed around the mesa M. The first conductivity type semiconductor layer 110 may be exposed in a ring shape along the mesa M, without being limited thereto. A portion of a side surface of the first conductivity type semiconductor layer 110 may be continuously connected to a side surface of the mesa M without a step.

The ohmic layer 150 may be disposed on a surface of the second conductivity type semiconductor layer 120. The ohmic layer 150 may be electrically connected to the second conductivity type semiconductor layer 120.

The ohmic layer 150 may be disposed substantially over the entirety of an upper region of the second conductivity type semiconductor layer 120. For example, the ohmic layer 150 may cover 80% or more, specifically 90% or more, of the upper region of the second conductivity type semiconductor layer 120.

The ohmic layer 150 may include a transparent layer. Thus, the ohmic layer 150 can transmit light that is generated in the active layer 130 and reaches the ohmic layer 150.

The ohmic layer 150 may include a transparent electrode, which may be a transparent oxide layer, such as ITO or ZnO. Alternatively, the ohmic layer 150 may include a single transparent electrode or a transparent metal.

Alternatively, the ohmic layer 150 may include a metal layer having reflective properties. Thus, the ohmic layer 150 can reflect light, which is generated in the active layer 130 and reaches the ohmic layer 150, back toward the substrate 101. The ohmic layer 150 may include a single reflective metal layer, without being limited thereto. The ohmic layer 150 may include a transparent electrode layer and a reflective metal layer.

As the ohmic layer 150, a metal layer, such as Ni, or a transparent oxide layer, such as ITO, may be used. Alternatively, a highly reflective metal layer, such as Ag or Al, may be used as the ohmic layer 150.

The transparent electrode layer of the ohmic layer 150 may have any thickness. The ohmic layer 150 may have a thickness of 35 µm or less. If the thickness of the transparent electrode layer of the ohmic layer 150 exceeds 35 µm, there is a problem of deterioration in efficiency of electrical connection between the second conductivity type semiconductor layer 120 and a second metal layer 180 described below. Furthermore, if the thickness of the transparent electrode layer of the ohmic layer 150 exceeds 35 µm, coupling force between the ohmic layer 150 and the second conductivity type semiconductor layer 120 can be reduced.

The transparent electrode layer of the ohmic layer 150 may include ITO or ZnO. The ohmic layer 150 may have a thickness of 30 µm or less in at least a region thereof. When the thickness of the ohmic layer 150 has a thickness of 30 µm or less, coupling force between the ohmic layer 150 and the second conductivity type semiconductor layer 120 can be improved together with electrical properties between the second conductivity type semiconductor layer 120 and the second metal layer 180. As a result, the internal quantum efficiency (EQE) of the light emitting device 100 can be increased, thereby improving light extraction efficiency and reliability.

The thickness of the transparent electrode layer of the ohmic layer 150 may be adjusted in various ways according to the planar size of the mesa M in longitudinal and transverse directions thereof to improve the internal quantum efficiency (EQE). For example, when the mesa M has a planar size of 75 µm x 30 µm, the transparent electrode layer may have a thickness of 10 µm or less. When the mesa M has a planar size of 75 µm x 30 µm or less, the transparent electrode layer may have a thickness of 5 µm or less. Accordingly, the transparent electrode layer having a thickness of 10 µm or less and formed on the mesa M having a planar size of 75 µm x 30 µm or less can more stably control electrical characteristics of electric current injected into the semiconductor layers and can improve transmission efficiency of light emitted from the semiconductor layers. In addition, this structure can improve heat dissipation efficiency of heat generated from the semiconductor layers while reducing ion mobility caused by external moisture, thereby improving reliability of the light emitting device 100.

The light emitting device 100 may include a first metal layer 170 disposed on the first conductivity type semiconductor layer 110 exposed around the mesa M and a second metal layer 180 disposed on the second conductivity type semiconductor layer 120. The second metal layer 180 may be disposed on the ohmic layer 150.

The first metal layer 170 and the second metal layer 180 may include a reflective layer, such as an Al layer. The reflective layer may include Ti, Cr, Ni, or others, and may be formed on a bonding layer. Further, a protective layer of a single layer or composite layer structure formed of Ni, Cr, or Au may be disposed on the reflective layer.

The insulating layer 160 may cover the first and second metal layers 170, 180 or the ohmic layer 150. The insulating layer 160 may also cover not only an upper surface of the mesa M exposed around the first and second metal layers 170, 180 or the ohmic layer 150, but also a side surface of the mesa M along the periphery thereof. In addition, the insulating layer 160 may at least partially cover the first conductive type semiconductor layer 110 exposed around the mesa M.

The insulating layer 160 may include a first opening 162 exposing the first conductivity type semiconductor layer 110 and a second opening 164 exposing the second conductivity type semiconductor layer 120.

At least a portion of the first metal layer 170 may be exposed through the first opening 162. A region of the first metal layer 170 may overlap the first opening 162.

At least a portion of the second metal layer 180 may be exposed through the second opening 164. A region of the second metal layer 180 or the ohmic layer 150 may overlap the second opening 164.

The insulating layer 160 may cover the first conductivity type semiconductor layer 110 at an edge of the substrate 101. However, the insulating layer 160 may also partially expose the upper surface of the first conductivity type semiconductor layer 110 along the edge of the substrate 101. Preferably, the shortest distance from the edge of the insulating layer 160 to the first metal layer 170 is longer to prevent moisture from penetrating and damaging the first metal layer 170 and may be about 15 µm or more. If the shortest distance from the edge of the insulating layer 160 to the first metal layer 170 is shorter than 15 µm, the first metal layer 170 is likely to be damaged by moisture when the light emitting device 100 is operated at a low current, for example, at 25 mA.

The insulating layer 160 may have a single layer structure of SiO2 or Si3N4, without being limited thereto. For example, the insulating layer 160 may have a multilayer structure including a silicon nitride film and a silicon oxide film. Alternatively, the insulating layer 160 may include a distributed Bragg reflector in which layers having different indexes of refraction, such as a SiO2 layer, a TiO2 layer, a ZrO2 layer, a MgF2 layer, and a Nb2O5 layer, are alternately stacked.

In addition, the insulating layer 160 may have the same stacking structure in the entire region thereof, without being limited thereto. For example, the insulating layer 160 may have a stacked structure in which a certain region of the structure includes a greater number of layers than other regions thereof. For example, the insulating layer 160 around the ohmic layer 150 may have a greater number of layers and a greater thickness than the insulating layer 160 on top of the ohmic layer 150.

The light emitting device 100 may further include a first pad 192 electrically connected to the first metal layer 170 exposed through the first opening 162 of the insulating layer 160, and a second pad 194 electrically connected to the second metal layer 180 exposed through the second opening 162 of the insulating layer 160.

The first pad 192 and the second pad 194 may be disposed over upper regions of the first metal layer 170 and the second metal layer 180, respectively. Accordingly, the first and second pads 192, 194 may be formed in relatively large sizes within a limited region of the light emitting device 100.

The first pad 192 and the second pad 194 serve to bond the light emitting device 100 to a sub-mount, a printed circuit board or the like, and may be formed of a material suitable for bonding.

For example, the first and second pads 192, 194 may include an Au layer or an AuSn layer. The first and second pads 192, 194 are connected to the first and second reflective layers 170, 180 exposed through the first and second openings 162, 164 of the insulating layer 160, respectively, thereby improving heat dissipation of the light emitting device 100.

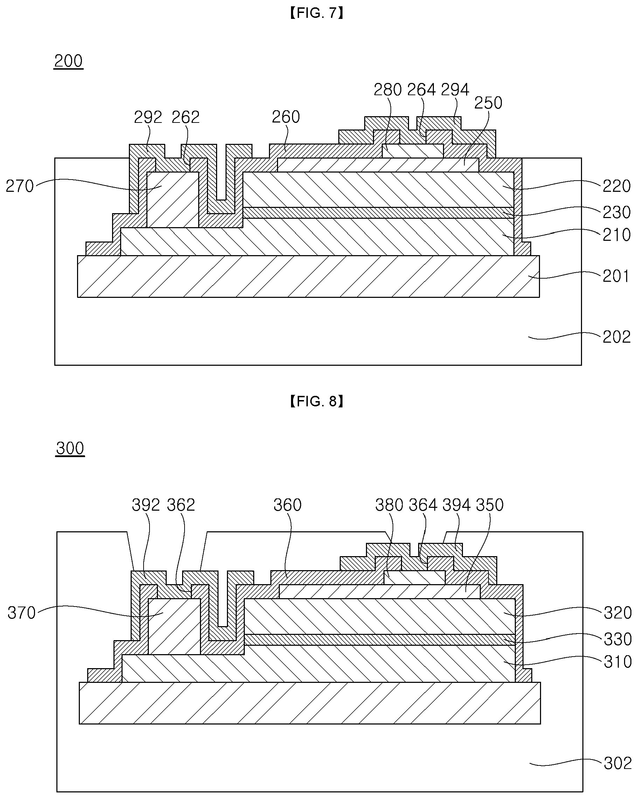

FIG. 7 shows a light emitting device 200 according to another embodiment of the disclosed technology. The following description will focus on different features of the light emitting device 200 from the light emitting device 100 according to the embodiment shown in FIG. 6. A light emitting device 300 shown in FIG. 8 is a variant of the light emitting device 200 shown in FIG. 7.

The light emitting devices 200; 300 shown in FIG. 7 and FIG. 8 may have the same or similar configuration to the light emitting device 100 according to the embodiment shown in FIG. 6, except that the light emitting devices 200; 300 further include optical filters 202; 302 covering at least a portion of a light emission surface.

In the light emitting devices 200; 300, active layers 230; 330 emit light having a first dominant wavelength and the optical filters 202; 302 may have the highest transmittance at the dominant wavelength.

Referring to FIG. 7 and FIG. 8, each of the optical filters 202; 302 is disposed in a region of a substrate 201 or 301 and a semiconductor stack and may cover a surface of the substrate 201 or 301.

The optical filters 202; 302 may be disposed to expose at least a portion of the semiconductor stack. In addition, the optical filters 202; 302 may include an insulating material.

The exposed regions of the optical filters 202; 302 may be openings for electrical connection of the light emitting devices 200; 300 to an external power source. The optical filters 202; 302 may be disposed to expose a surface and a region of a side surface of the semiconductor stack. The optical filters 202, 303 may be disposed to cover the entirety of the side surface of the semiconductor stack while partially expose a surface thereof.

The optical filters 202; 302 may have the highest light transmittance at a dominant wavelength of the semiconductor stack. The optical filters 202; 302 may have a transmittance of 50% or less for light at wavelengths separated by -20 nm to +20 nm outward from the dominant wavelength of the semiconductor stack.

Thus, light emitted through the optical filters 202; 302 may have a light characteristic of a full-width at half maximum of 40 nm or less. The optical filters 202; 302 may have a transmittance of 50% or less for light at a wavelengths separated by -10 nm to +10 nm outward from the dominant wavelength of the semiconductor stack. Thus, light emitted through the optical filters 202; 302 may have light characteristics of a full-width at half maximum of 20 nm or less. Accordingly, color purity and visibility of colors of light emitted from the light emitting devices 200; 300 can be improved.

The optical filters 202; 302 may include color filters. Alternatively, the optical filters 202; 302 may include band pass filters. Alternatively, the optical filters 202; 302 may include distributed Bragg reflectors in which layers having different indexes of refraction, such as a SiO2 layer, a TiO2 layer, a ZrO2 layer, a MgF2 layer, and a Nb2O5 layer, are alternately stacked.

The light emitting devices 100, 200, 300 described above may have an area of 10,000 µm2 or less. Alternatively, the light emitting devices 100, 200, 300 may have the longest length of 100 µm or less among transverse or longitudinal lengths thereof. When an electric source, such as current or voltage is supplied to the light emitting devices 100, 200, 300, each of the light emitting devices 100, 200, 300 may include a light emission region ER from which light is emitted when viewed in a direction of a surface of the first conductivity type semiconductor layer 110 or in a direction of a surface of the second conductivity type semiconductor layer 120. The light emission region ER may be placed in an interior region of the mesa M.

The light emission region ER may have the highest luminous intensity at a center thereof and a luminous intensity gradually decreasing from the center thereof. Alternatively, the luminous intensity at the center of the light emission region ER may be different from the luminous intensity at edges thereof.

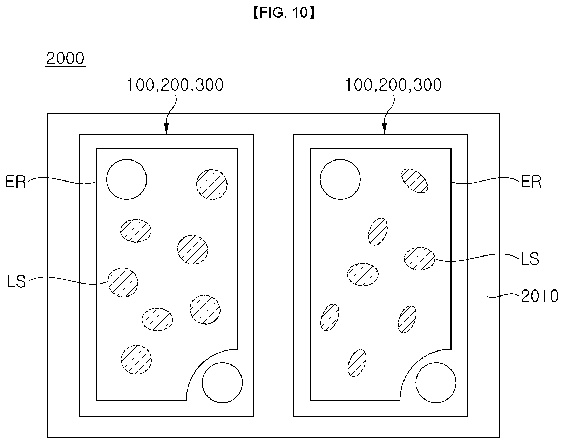

Referring to FIG. 10, each of the light emitting devices 100, 200, 300 may include at least one light emitting zone LS in the light emission region ER. That is, the light emitting zone LS may be disposed within the mesa M. The light emitting zone LS may have the highest luminous intensity at a center thereof and luminous intensity gradually decreasing from the center thereof. Alternatively, the luminous intensity at the center of the light emitting zone LS may be different from the luminous intensity at edges of the light emitting zone and may be higher than the luminous intensity at the edges of the light emitting zone. The light emitting zone LS may have a circular shape or a nonuniform shape. The light emitting zone LS may be arranged in an island shape.

The radius or shape of the light emitting zone LS may be changed according to electric current. For example, the size of the light emitting zone LS formed when relatively low electric current is supplied to the light emitting devices 100, 200, 300 may be smaller than the size of the light emitting zone LS formed when relatively high electric current is supplied to the light emitting devices 100, 200, 300.

The light emitting zone LS may be provided singularly or in plural. At least one light emitting zone LS may have a different size or shape than the other light emitting zone LS. In addition, at least one light emitting zone LS may have different luminous intensity than the other light emitting zones LS.

A light emitting module according to the disclosed technology may include the light emitting devices 100, 200, 300 described above.

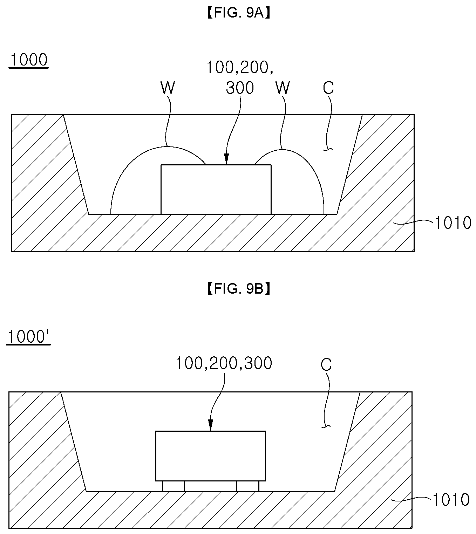

First, FIG. 9A shows a light emitting module according to a first embodiment of the disclosed technology, which may be a light emitting diode package 1000 including at least one light emitting device 100, 200, 300.

The light emitting diode package 1000 may include at least one light emitting device 100, 200, 300 and a lead frame 1010 on which the light emitting device 100, 200, 300 is mounted. The light emitting devices 100, 200, 300 may be electrically connected to electrodes on the lead frame 1010 via wires W.

The lead frame 1010 may be provided with a cavity C for receiving the light emitting device 100, 200, 300. A sidewall of the lead frame 1010 defining the cavity C may form a sloped surface, which may be a reflective surface, from which light emitted from the light emitting device 100, 200, 300 is reflected.

The light emitting diode package 1000 may further include a molding member disposed in the cavity C. The molding member may include a transparent molding. Alternatively, the molding member may include a wavelength conversion material. Alternatively, the molding member may further include a light absorbing material, a light reflecting material, or a light scattering material.

Next, a light emitting diode package 1000' shown in FIG. 9B is a variant of the light emitting diode package 1000 shown in FIG. 9A and may have the same or similar configuration to the light emitting package 1000 shown in FIG. 9A except that the light emitting devices 100, 200, 300 are of a flip-chip type and are soldered to the lead frame 1010 through bumps.

Next, FIG. 10 shows a light emitting module 2000 according to a second embodiment of the disclosed technology, which may include at least one light emitting device 100, 200, 300. The light emitting module 2000 may include a substrate 2010 and at least one light emitting device 100, 200, 300 disposed on the substrate 2010.

The light emitting module 2000 may include a plurality of light emitting devices 100, 200, 300. Although FIG. 10 illustrates an example in which the light emitting module 2000 includes two light emitting devices 100, 200, 300, it should be understood that other implementations are possible. Referring to FIG. 10, the light emitting zones LS of the light emitting devices 100, 200, 300 may have different sizes or shapes, respectively. In addition, each of the light emitting zones LS of the light emitting devices 100, 200, 300 may have different luminous intensity. Further, the light emitting zones LS of the light emitting devices 100, 200, 300 may be placed at different locations (that is, locations (x, y) in the light emission regions ER), respectively. Further, light emitted from the light emitting zones LS of the light emitting devices 100, 200, 300 may have different color coordinates, respectively. Further, light emitted from each of the light emitting devices 100, 200, 300 may have a different peak wavelength. Further, light emitted from each of the light emitting devices 100, 200, 300 may have a different full width at half maximum (FWHM). The light emitted from the light emitting zone LS of each of the light emitting devices 100, 200, 300 may have a peak wavelength and a dominant wavelength, and a difference value between the peak wavelength and the dominant wavelength of light emitted from each of the light emitting devices 100, 200, 300 may be different from that of the other light emitting devices.

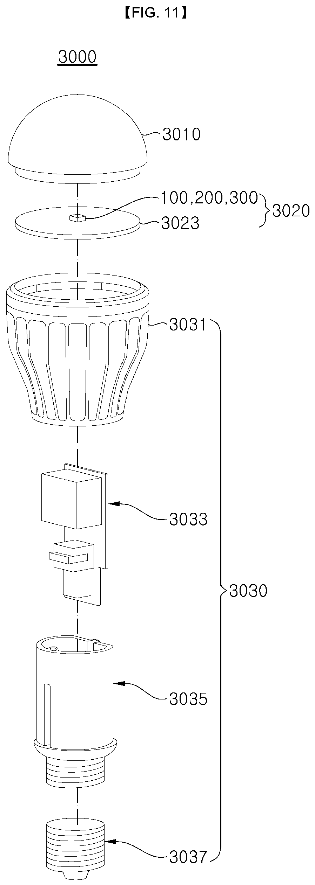

Next, FIG. 11 is an exploded perspective view of a light emitting module according to a third embodiment of the disclosed technology, wherein the light emitting module may be a lighting apparatus 3000 including at least one of the light emitting devices 100, 200, 300 described above.

Referring to FIG. 11, the lighting apparatus 3000 according to this embodiment includes a diffusive cover 3010, a light source module 3020, and a body 3030. The body 3030 may receive the light source module 3020 and the diffusive cover 3010 may be disposed on the body 3030 to cover an upper side of the light source module 3020.

The body 3030 may have any shape so long as the body can supply electric power to the light source module 3020 while receiving and supporting the light source module 3020. For example, as shown in the drawing, the body 3030 may include a body case 3031, a power supply 3033, a power source case 3035, and a power source connector 3037.

The power supply 3033 is received in the power source case 3035 to be electrically connected to the light source module 3020 and may include at least one IC chip. The IC chip may regulate, change or control electric power supplied to the light source module 3020. The power source case 3035 may receive and support the power supply 3033 and the power source case 3035 having the power supply 3033 secured therein may be disposed within the body case 3031. The power source connector 3037 may be disposed at a lower end of the power source case 3035 to be coupled thereto. Accordingly, the power source connector 3037 is electrically connected to the power supply 3033 within the power source case 3035 and may serve as a passage through which power can be supplied from an external power source to the power supply 3033.

The light source module 3020 may include a substrate 3023 and at least one light emitting device 100, 200, 300 disposed on the substrate 3023. The light source module 3020 may be disposed at an upper portion of the body case 3031 and electrically connected to the power supply 3033.

As the substrate 3023, any substrate capable of supporting the at least one light emitting device 100, 200, 300 may be used without limitation. For example, the substrate 3023 may include a printed circuit board having interconnects formed thereon. The substrate 3023 may have a shape corresponding to a securing portion formed at the upper portion of the body case 3031 so as to be stably secured to the body case 3031.

The diffusive cover 3010 is disposed on the light emitting devices 100, 200, 300 and may be secured to the body case 3031 to cover the light emitting devices 100, 200, 300. The diffusive cover 3010 may be formed of a light transmitting material and light orientation of the lighting apparatus may be adjusted through regulation of the shape and light transmissivity of the diffusive cover 3010. Thus, the diffusive cover 3010 may be modified to have various shapes depending on usage and applications of the lighting apparatus.

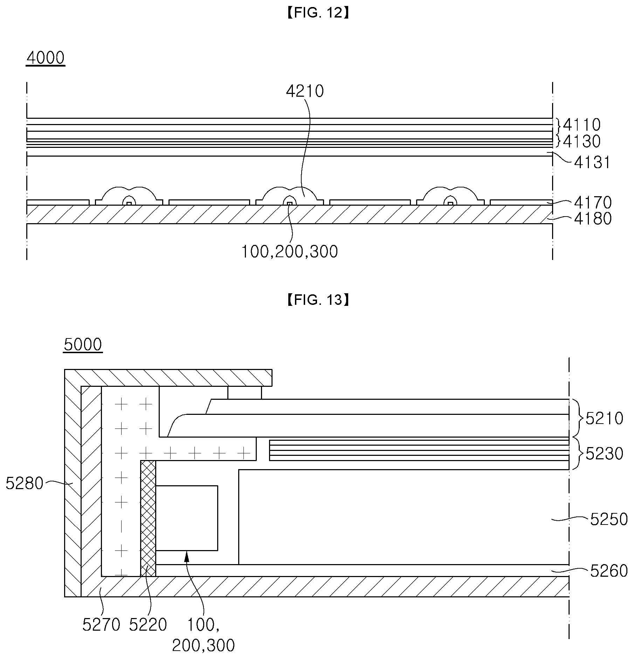

Next, FIG. 12 is a side sectional view of a light emitting module according to a fourth embodiment of the disclosed technology, wherein the light emitting module may be a display apparatus 4000 including at least one of the light emitting devices 100, 200, 300 described above.

The display apparatus 4000 may include a display panel 4110, a backlight unit supplying light to the display panel 4110, and a panel guide supporting a lower edge of the display panel 4110.

The display panel 4110 is not particularly limited and may be, for example, a liquid crystal panel including a liquid crystal layer. Gate driving PCBs may be further disposed at the periphery of the display panel 4110 to supply driving signals to a gate line. Here, the gate driving PCBs may be formed on a thin film transistor substrate instead of being formed on separate PCBs. Pixels of the display panel 4110 may be LED displays implemented by the light emitting devices 100, 200, 300 according to the disclosed technology. When the display panel 4110 is an LED display, the backlight unit described hereinafter may be omitted.

The backlight unit includes a light source module which includes at least one substrate and a plurality of light emitting devices 100, 200, 300. The backlight unit may further include a bottom cover 4180, a reflective sheet 4170, a diffusive plate 4131, and optical sheets 4130.

The bottom cover 4180 may be open at an upper side thereof to receive the substrate, the light emitting devices 100, 200, 300, the reflective sheet 4170, the diffusive plate 4131, and the optical sheets 4130. In addition, the bottom cover 4180 may be coupled to the panel guide. The substrate may be disposed under the reflective sheet 4170 to be surrounded by the reflective sheet 4170.

Alternatively, when a reflective material is coated on a surface thereof, the substrate may be disposed on the reflective sheet 4170. Further, a plurality of substrates may be arranged parallel to one another, without being limited thereto. However, it should be understood that the backlight unit includes a single substrate.

The light emitting devices 100, 200, 300 may be regularly arranged in a predetermined pattern on the substrate. In addition, a lens 4210 may be disposed on each of the light emitting devices 100, 200, 300 to improve uniformity of light emitted from the plurality of light emitting devices 100, 200, 300.

The diffusive plate 4131 and the optical sheets 4130 are disposed above the light emitting devices 100, 200, 300. Light emitted from the light emitting devices 100, 200, 300 may be supplied in the form of sheet light to the display panel 4110 through the diffusive plate 4131 and the optical sheets 4130.

As such, the light emitting devices 100, 200, 300 according to the embodiments of the disclosed technology may be applied to direct type displays like the display apparatus 4000 according to this embodiment.

Next, FIG. 13 is a side sectional view of a light emitting module according to a fifth embodiment of the disclosed technology, wherein the light emitting module may be may be a display apparatus 5000 including at least one of the light emitting devices 100, 200, 300 described above.

The display apparatus 5000 according to the fifth embodiment includes a display panel 5210 on which an image is displayed, and a backlight unit disposed at a rear side of the display panel 5210 and emitting light thereto. Further, the display apparatus includes a frame supporting the display panel 5210 and receiving the backlight unit, and covers 5270, 5280 surrounding the display panel 5210.

The display panel 5210 is not particularly limited and may include, for example, a liquid crystal panel including a liquid crystal layer. A gate driving PCB may be further disposed at the periphery of the display panel 5210 to supply driving signals to a gate line. Here, the gate driving PCB may be formed on a thin film transistor substrate instead of being formed on a separate PCB. The display panel 5210 is secured by the covers 5270, 5280 disposed at upper and lower sides thereof, and the cover 5280 disposed at the lower side of the display panel 5210 may be coupled to the backlight unit.

The backlight unit adapted to supply light to the display panel 5210 includes a lower cover 5270 partially open at an upper side thereof, a light source module disposed at one side inside the lower cover 5270, and a light guide plate 5250 disposed parallel to the light source module and converting spot light into sheet light. In addition, the backlight unit according to this embodiment may further include optical sheets 5230 disposed on the light guide plate 5250 to spread and collect light, and a reflective sheet 5260 disposed at a lower side of the light guide plate 5250 and reflecting light traveling in a downward direction of the light guide plate 5250 towards the display panel 5210.

The light source module includes a substrate 5220 and a plurality of light emitting devices 100, 200, 300 arranged at constant intervals on a surface of the substrate 5220. As the substrate 5220, any substrate capable of supporting the light emitting devices 100, 200, 300 and being electrically connected thereto may be used without limitation. For example, the substrate 5220 may include a printed circuit board.

Light emitted from the light source module enters the light guide plate 5250 and is supplied to the display panel 5210 through the optical sheets 5230. The light guide plate 5250 and the optical sheets 5230 convert spot light emitted from the light emitting devices 100, 200, 300 into sheet light.

As such, the light emitting devices 100, 200, 300 according to the embodiments may be applied to edge type displays like the display apparatus 5000 according to this embodiment.

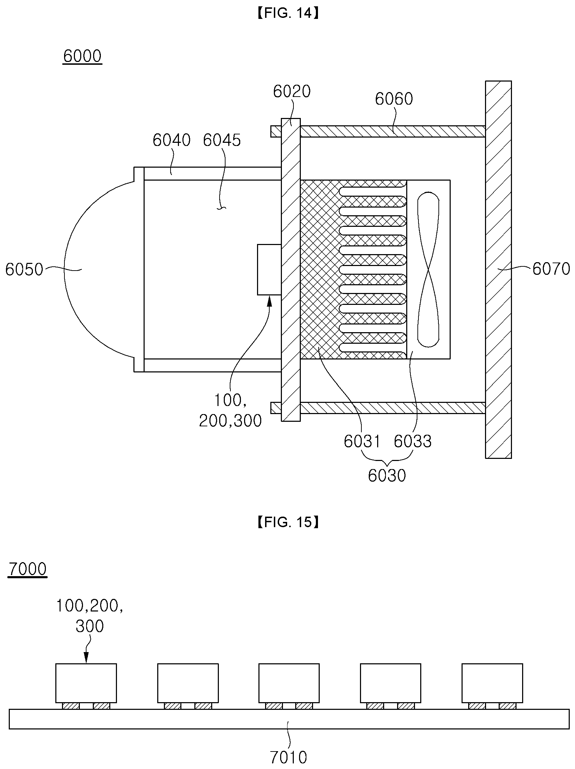

Next, FIG. 14 is a side sectional view of a light emitting module according to a sixth embodiment of the disclosed technology, wherein the light emitting module may be a head lamp 6000 including at least one of the light emitting devices 100, 200, 300 described above.

Referring to FIG. 14, the head lamp 6000 may include a lamp body 6070, a substrate 6020, the light emitting devices 100, 200, 300, and a cover lens 6050. Further, the head lamp 6000 may further include a heat dissipation unit 6030, a support rack 6060, and a connection member 6040.

The substrate 6020 may be secured by the support rack 6060 and may be disposed above the lamp body 6070. As the substrate 6020, any substrate capable of supporting the light emitting devices 100, 200, 300 may be used without limitation. For example, the substrate 6020 may include a substrate having a conductive pattern, such as a printed circuit board. The light emitting devices 100, 200, 300 are disposed on the substrate 6020 and may be supported and secured by the substrate 6020. In addition, the light emitting devices 100, 200, 300 may be electrically connected to an external power source through the conductive pattern of the substrate 6020.

The cover lens 6050 is disposed on a path of light emitted from the light emitting devices 100, 200, 300. For example, as shown in the drawing, the cover lens 6050 may be separated from the light emitting devices 100, 200, 300 by the connection member 6040 and may be disposed in a direction of supplying light emitted from the light emitting devices 100, 200, 300. By the cover lens 6050, a beam angle and/or a color of light emitted by the head lamp can be adjusted.

The connection member 6040 is disposed to secure the cover lens 6050 to the substrate 6020 while surrounding the light emitting devices 100, 200, 300, and thus may act as a light guide that provides a luminous path 6045. The connection member 6040 may be formed of a light reflective material or coated therewith. On the other hand, the heat dissipation unit 6030 may include heat dissipation fins 6031 and/or a heat dissipation fan 6033 to dissipate heat generated upon operation of the light emitting devices 100, 200, 300.

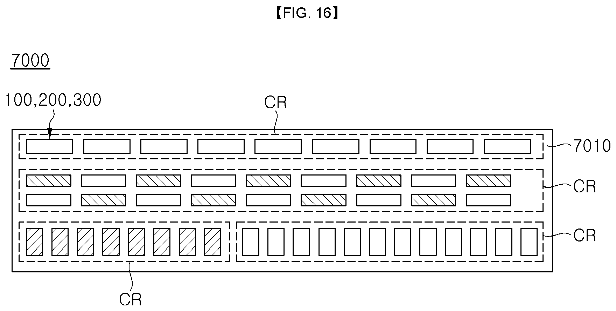

Next, FIG. 15 and FIG. 16 are side and plan views of a light emitting module 7000 according to a seventh embodiment of the disclosed technology, respectively, wherein the light emitting module 7000 may include at least one of the aforementioned light emitting devices 100, 200, 300 and a module substrate 7010 on which the light emitting devices 100, 200, 300 are disposed. The light emitting module 7000 may include a plurality of control regions CRs. The plurality of control regions CRs may be individually controlled by a controller.

The plurality of control regions CRs may include one or more light emitting devices 100, 200, 300. At least one of the control regions CRs may include a plurality of light emitting devices 100, 200, 300. When one control region (CR) includes a plurality of light emitting devices 100, 200, 300, the plurality of light emitting devices 100, 200, 300 may be individually turned on or off. In the plurality of light emitting devices 100, 200, 300, the first conductivity type semiconductor layers 110, 210, 310 may have the same arrangement direction as the second conductivity type semiconductor layers 120, 220, 320. The plurality of light emitting devices 100, 200, 300 may include the same group V material.

The plurality of light emitting devices 100, 200, 300 may have a peak wavelength of 500 nm to 600 nm. Alternatively, the plurality of light emitting devices 100, 200, 300 may have a peak wavelength of 480 nm to 550 nm. Alternatively, the plurality of light emitting devices 100, 200, 300 may have a peak wavelength of 430 nm to 480 nm. Alternatively, the plurality of light emitting devices 100, 200, 300 may emit white light.

At least one of the plurality of control regions CRs may include the plurality of light emitting devices 100, 200, 300 and a plurality of groups may be present within one control region CR. Here, each group may include a plurality of light emitting devices 100, 200, 300 electrically connected to each other. For example, one control region CR may include a first group of light emitting devices 100, 200, 300 electrically connected to each other and a second group of light emitting devices 100, 200, 300 electrically connected to each other. The plurality of groups may be individually controlled. By way of example, the first group and the second group may be individually turned on or off.

The plurality of groups may be simultaneously turned on or off, or may be temporarily simultaneously turned on or off. By way of example, the first group and the second group may be simultaneously turned on or off, or may be temporarily simultaneously turned on or off.

The light emitting devices 100, 200, 300 in the plurality of groups may have a peak wavelength of 550 nm to 650 nm. For example, the light emitting devices 100, 200, 300 of the first group and the second group may have a peak wavelength of 550 nm to 650 nm.

In the light emitting devices 100, 200, 300 of each group, the first conductivity type semiconductor layers 110, 210, 310 may have the same arrangement direction as the second conductivity type semiconductor layers 120, 220, 320. For example, in the light emitting devices 100, 200, 300 of the first group, the first conductivity type semiconductor layers 110, 210, 310 may have the same arrangement direction as the second conductivity type semiconductor layer 120, 220, 320. In the plurality of light emitting devices 100, 200, 300 of the second group, the first conductivity type semiconductor layer 110, 210, 310 may have the same arrangement direction as the second conductivity type semiconductor layer 120, 220, 320. In the plurality of light emitting devices 100, 200, 300 of the first group and the plurality of light emitting devices 100, 200, 300 of the second group, the first conductivity type semiconductor layers 110, 210, 310 may have the same arrangement direction as the second conductivity type semiconductor layers 120, 220, 320.

Although some exemplary embodiments have been described herein with reference to the accompanying drawings, it should be understood that various modifications and changes can be made by those skilled in the art or by a person having ordinary knowledge in the art without departing from the spirit and scope of the invention, as defined by the claims and equivalents thereto.

Therefore, the scope of the invention should be defined by the appended claims and equivalents thereto instead of being limited to the detailed description of the invention.

### [Examples]

### [Example 1]

A light emitting module comprising at least one light emitting device,
wherein the light emitting device includes: a first conductivity type semiconductor layer; a second conductivity type semiconductor layer; an active layer interposed between the first conductivity type semiconductor layer and the second conductivity type semiconductor layer; and an electron blocking layer disposed between the active layer and the second conductivity type semiconductor layer,
wherein the electron blocking layer includes at least one shading region having a lower thickness than an adjacent region.

### [Example 2]

The light emitting module according to example 1, wherein a difference in lattice constant between the electron blocking layer in the shading region and the second conductivity type semiconductor layer is less than a difference in lattice constant between the electron blocking layer in other regions excluding the shading region and the second conductivity type semiconductor layer.

### [Example 3]

The light emitting module according to example 1, wherein the shading region in the electron blocking layer has a smaller width than another shading region adjacent thereto.

### [Example 4]

The light emitting module according to example 1, wherein the thickness of the shading region is 70% or less of the thickness of the adjacent region.

### [Example 5]

The light emitting module according to example 1, wherein the shading region is a concavely recessed region on a surface of the electron blocking layer.

### [Example 6]

The light emitting module according to example 1, wherein
the second conductivity type semiconductor layer includes a second-1 conductivity type semiconductor layer disposed at one side of the electron blocking layer, and a second-2 conductivity type semiconductor layer disposed at one side of the second-1 conductivity type semiconductor layer, and
the second-1 conductivity type semiconductor layer has a higher concentration of second conductivity type dopants than the second-2 conductivity type semiconductor layer.

### [Example 7]

The light emitting module according to example 1, wherein the first conductive type semiconductor layer includes a superlattice layer disposed at one side of the active layer.

### [Example 8]

The light emitting module according to example 1,
further comprising an ohmic layer disposed on a surface of the second conductivity type semiconductor layer.

### [Example 9]

The light emitting module according to example 8,
wherein the ohmic layer covers 80% or more of an upper region of the second conductivity type semiconductor layer.

### [Example 10]

The light emitting module according to example 1,
further comprising a mesa disposed in a region of the first conductivity type semiconductor layer to expose an upper surface of the first conductivity type semiconductor layer.

### [Example 11]

The light emitting module according to example 10,
further comprising an insulating layer covering at least a portion of the mesa.

### [Example 12]

The light emitting module according to example 1,
further comprising an optical filter covering at least a portion of a light emission surface.

### [Example 13]

The light emitting module according to example 1,
wherein the active layer emits light having a dominant wavelength of 440nm to 480nm, 480nm to 580nm, or 600nm or 650nm.

### [Example 14]

The light emitting module according to example 1,
further comprising a substrate having a pattern formed on a surface thereof,
wherein the pattern includes irregularities or protrusions.

### [Example 15]

The light emitting module according to example 1,
wherein the active layer includes a barrier layer and a well layer,
wherein a difference in energy bandgap between the first conductivity type semiconductor layer and the well layer is greater than or equal to 2 times a difference in energy bandgap between the first conductivity type semiconductor layer and the barrier layer.

## Claims

1. A light emitting module comprising at least one light emitting device,
wherein the light emitting device comprises: a first conductivity type semiconductor layer; a second conductivity type semiconductor layer; and an active layer interposed between the first conductivity type semiconductor layer and the second conductivity type semiconductor layer,
wherein the active layer includes a multi-quantum well structure comprising barrier layers and well layers alternately disposed therein, and
wherein the well layer includes at least one shading region having a lower thickness than an adjacent region.

2. The light emitting module according to claim 1, wherein holes have higher mobility in the shading region than holes in other regions excluding the shading region.

3. The light emitting module according to claim 1, wherein the shading region in the well layer has a smaller width than another shading region adjacent thereto.

4. The light emitting module according to claim 1, wherein the thickness of the shading region is 70% of the thickness of the adjacent region.

5. The light emitting module according to claim 1, wherein the shading region is a concavely recessed region on one surface of the well layer.

6. The light emitting module according to claim 1,
wherein a separation distance between two adjacent shading regions is greater than the width of the shading region.

7. The light emitting module according to claim 1,
further comprising a patterned sapphire substrate on which the first conductivity type semiconductor layer disposed.

8. The light emitting module according to claim 1,
wherein a difference in energy bandgap between the second conductivity type semiconductor layer and the well layer is greater than or equal to 2 times a difference in energy bandgap between the second conductivity type semiconductor layer and the barrier layer.

9. The light emitting module according to claim 1,
further comprising a mesa structure having the active layer that have a smaller area than the first conductivity type semiconductor layer.

10. The light emitting module according to claim 1,
further comprising an ohmic layer disposed on a surface of the second conductivity type semiconductor layer,
wherein the ohmic layer includes a transparent electrode having ITO or ZnO.

11. The light emitting module according to claim 1,
further include a first pad electrically connected to the first conductivity type semiconductor layer and a second pad electrically connected to the second conductivity type semiconductor layer,
wherein the first pad and the second pad include Au layer or AuSn layer.

12. The light emitting module according to claim 1,
further comprising a diffusive cover configured to cover the light emitting device to adjust light orientation.

13. The light emitting module according to claim 1,
wherein the light emitting module is a display apparatus,
further comprising a light guide plate configured to covert spot light emitted from the light emitting device into the sheet light.

14. The light emitting module according to claim 1,
wherein light emitted from the light emitting device has a peak wavelength of 430 nm to 480 nm, 480 nm to 550 nm, or 500 nm to 600 nm.

15. The light emitting module according to claim 1,
wherein the well layer and the barrier layer include at least one of InGaN/GaN, GaN/AlGaN, AlGaN/AlGaN, InGaN/AlGaN, or InGaN/InGaN.
